# EUROPEAN PATENT APPLICATION

(11) **EP 3 780 086 A1**
(43) Date of publication of application: **17.02.2021**
(21) Application number: 19775884.0
(22) Date of filing: 29.03.2019
(51) Int. Cl.: H01L 23/36, C01F 7/02, C04B 35/626, C04B 35/628, C08K 3/28, C08L 101/00, H01B 3/30, H01L 23/12, H01L 23/373, H05K 1/05

(54) **THERMALLY CONDUCTIVE COMPOSITE PARTICLES, METHOD FOR PRODUCING SAME, INSULATING RESIN COMPOSITION, INSULATING RESIN MOLDED BODY, LAMINATE FOR CIRCUIT BOARDS, METAL BASE CIRCUIT BOARD AND POWER MODULE**

(30) Priority: 30.03.2018 JP 2018068772
(71) Applicant: NHK Spring Co., Ltd., Yokohama-shi, Kanagawa 236-0004 (JP)
(72) Inventor: SUZUKI, Kohei, Yokohama-shi, Kanagawa 236-0004 (JP); MARUICHI, Toshiaki, Yokohama-shi, Kanagawa 236-0004 (JP)
(74) Representative: Zech, Stefan Markus
(86) International application number: PCT/JP2019/014078
(87) International publication number: WO 2019/189794

(57) **Abstract**

A thermally conductive composite particle, including: a core portion including an inorganic particle; and a shell portion including a nitride particle and covering the core portion, is provided. The thermally conductive composite particle is a sintered body.

## Description

### FIELD

The present invention relates to a thermally conductive composite particle, a method of manufacturing the same, an insulating resin composition, an insulating resin molded article, a circuit board laminate, a metal base circuit board, and a power module.

### BACKGROUND

The progress of electronics technology in recent years has been remarkable, with electrical and electronic equipment continuing to become rapidly more sophisticated and smaller. In accordance therewith, the amount of heat generation from an electric element and/or a component in which an electric element is mounted is becoming progressively larger. In this situation, excellent heat dissipating properties are required for metal base circuit boards in which so-called power devices, whose typical examples are metal-oxide-semiconductor field-effect transistor (MOSFET), insulated-gate bipolar transistor (IGBT) and the like, are mounted.

The metal base circuit board has a structure in which an insulating layer and a circuit pattern are laminated in this order on a metal substrate. In order to enhance the heat dissipating property of the metal base circuit board, for a resin serving as a base material of the insulating layer, inorganic powder having high thermal conductivity and electrical insulation properties, such as alumina powder, magnesia powder, boron nitride powder, and silicon nitride powder, is generally used as a filler.

Among inorganic powders, boron nitride and silicon nitride have particularly high thermal conductivity. However, as boron nitride has a hexagonal scaly crystal structure and silicon nitride is a rod-like crystal, they have anisotropic thermal conductivities, and an inorganic filler-containing resin composition can be easily oriented when molded into a sheet shape by a publicly-known molding method such as a press molding method, an injection molding method, an extrusion molding method, a calendar molding method, a roll molding method, or a doctor blade molding method. Therefore, there has been a problem that the thermal conductivity of the obtained resin molded article also becomes anisotropic.

Various techniques have been developed to solve the problem that the thermal conductivity of the inorganic filler is anisotropic and the thermal conductivity of the resin molded article in which the inorganic filler is dispersed also becomes anisotropic. For example, Patent Literature 1 discloses a core-shell particle as an inorganic filler using scaly boron nitride, in which an inorganic particle such as aluminum oxide, silicon dioxide, or the like is a core portion, while a shell portion covering a periphery of the core portion contains scaly boron nitride and a binder resin (binder) (claims). This literature describes that a plurality of boron nitrides aggregate to form a spherical core-shell particle (paragraph 0021). Patent Literature 2 discloses an aggregate particle in which small-sized fillers aggregate around a relatively large-sized filler (claims). This literature describes that with the structure in which the small-sized fillers randomly protrude from an outer periphery of the large-sized filler, the heat transfers in various directions (isotropic), not a given single direction (anisotropic) (paragraph 0016).

### CITATION LIST

### PATENT LITERATURES

Patent Literature 1: Jpn. Pat. Appln. KOKAI Publication No. 2016-192474
Patent Literature 2: Japanese Patent No. 5115029

### SUMMARY

### TECHNICAL PROBLEM

The present inventors conducted intensive studies and found it difficult to obtain a resin molded article having a desired high thermal conductivity by using an inorganic filler in which inorganic particles having anisotropic thermal conductivity aggregate around an inorganic particle serving as a core, as disclosed in Patent Literatures 1 and 2.

An object of the present invention is to provide an inorganic filler excellent in thermal conductivity and a method of manufacturing the same. Furthermore, an object of the present invention is to provide an insulating resin composition containing an inorganic filler having excellent thermal conductivity, an insulating resin molded article, a circuit board laminate, a metal base circuit board, and a power module.

### SOLUTION TO PROBLEM

According to an aspect of the present invention, there is provided a thermally conductive composite particle as a sintered body, comprising: a core portion including an inorganic particle; and a shell portion including a nitride particle and covering the core portion.

According to another aspect of the present invention, the thermally conductive composite particle includes at least boron nitride or silicon nitride as the nitride particle.

According to another aspect of the present invention, in the thermally conductive composite particle, at least part of the shell portion is layered, and covers at least part of the core portion along a shape of the core portion.

According to another aspect of the present invention, in the thermally conductive composite particle, the shell portion is a sintered member of a mixture including the nitride particle and a sintering aid, and the shell portion includes an atom derived from the sintering aid.

According to another aspect of the present invention, in the thermally conductive composite particle, the sintering aid is at least one selected from Y₂O₃, CeO₂, La₂O₃, Yb₂O₃, TiO₂, ZrO₂, Fe₂O₃, MoO, MgO, Al₂O₃, CaO, B₄C, or B.

According to another aspect of the present invention, in the thermally conductive composite particle, part of the atoms derived from the sintering aid is unevenly distributed on a surface of the core portion.

According to another aspect of the present invention, in the thermally conductive composite particle, the shell portion includes at least yttrium as the atom derived from the sintering aid.

According to another aspect of the present invention, in the thermally conductive composite particle, a total volume of the nitride particle and the sintering aid with respect to a total volume of the inorganic particle, the nitride particle, and the sintering aid is 30% by volume or more.

According to another aspect of the present invention, in the thermally conductive composite particle, a compounding ratio of the sintering aid to the nitride particle is 5% by volume to 10% by volume.

According to another aspect of the present invention, in the thermally conductive composite particle, the inorganic particle is aluminum oxide or magnesium oxide.

According to another aspect of the present invention, there is provided a method of manufacturing a thermally conductive composite particle as a sintered body, the particle comprising a core portion including an inorganic particle, and a shell portion including a nitride particle and covering the core portion, in which the method comprises: forming a core-shell particle by subjecting a raw material including an inorganic particle and a nitride particle to mechanochemical treatment, the core-shell particle comprising a core portion including the inorganic particle, and a shell portion including the nitride particle and covering the core portion; and sintering the core-shell particle.

According to another aspect of the present invention, in the method, the shell portion of the thermally conductive composite particle includes at least boron nitride or silicon nitride as the nitride particle.

According to another aspect of the present invention, in the method, boron nitride, having at least a B₂O₃ content rate of 1% by mass or more or an oxygen content rate of 1% by mass or more as an impurity concentration, is used as the nitride particle of the raw material.

According to another aspect of the present invention, in the method, the raw material further includes at least one sintering aid selected from Y₂O₃, CeO₂, La₂O₃, Yb₂O₃, TiO₂, ZrO₂, Fe₂O₃, MoO, MgO, Al₂O₃, CaO, B₄C, or B, and the shell portion of the thermally conductive composite particle includes an atom derived from the sintering aid.

According to another aspect of the present invention, in the method, part of the atoms derived from the sintering aid is unevenly distributed on a surface of the core portion of the thermally conductive composite particle.

According to another aspect of the present invention, in the method, the raw material includes at least Y₂O₃ as the sintering aid, and the atom derived from the sintering aid is yttrium.

According to another aspect of the present invention, in the method, a total volume of the nitride particle and the sintering aid with respect to a total volume of the inorganic particle, the nitride particle, and the sintering aid included in the raw material is 30% by volume or more.

According to another aspect of the present invention, in the method, a ratio of the sintering aid to the nitride particle included in the raw material is 5 to 10% by volume.

According to another aspect of the present invention, in the method, the inorganic particle is aluminum oxide or magnesium oxide.

According to another aspect of the present invention, there is provided an insulating resin composition, comprising any of the thermally conductive composite particles described above.

According to another aspect of the present invention, there is provided an insulating resin molded article, obtainable by molding the insulating resin composition described above.

According to another aspect of the present invention, there is provided a circuit board laminate comprising: a metal substrate; an insulating layer provided on at least one surface of the metal substrate; and a metal foil provided on the insulating layer, in which the insulating layer comprises any of the thermally conductive composite particles described above.

According to another aspect of the present invention, there is provided a metal base circuit board comprising: a metal substrate; an insulating layer provided on at least one surface of the metal substrate; and a metal pattern provided on the insulating layer, in which the insulating layer comprises any of the thermally conductive composite particles described above.

According to another aspect of the present invention, there is provided a power module, comprising the metal base circuit board described above.

### ADVANTAGEOUS EFFECTS OF INVENTION

According to the present invention, it is possible to provide an inorganic filler having excellent thermal conductivity and a method of manufacturing the same. Furthermore, according to the present invention, it is possible to provide an insulating resin composition containing an inorganic filler having excellent thermal conductivity, an insulating resin molded article, a circuit board laminate, a metal base circuit board, and a power module.

### BRIEF DESCRIPTION OF THE DRAWINGS

FIG. 1 is an SEM photograph showing an example of a thermally conductive composite particle according to an embodiment;
FIG. 2 is an SEM photograph showing an example of a thermally conductive composite particle according to an embodiment;
FIG. 3 is an SEM photograph showing an example of a cross section of a thermally conductive composite particle according to an embodiment;
FIG. 4 is an SEM photograph showing an example of a cross section of a thermally conductive composite particle according to an embodiment;
FIG. 5 is a perspective view schematically showing a circuit board laminate according to an embodiment;
FIG. 6 is a cross-sectional view taken along line II-II of the circuit board laminate of FIG. 5;
FIG. 7 is a cross-sectional view schematically showing an example of a circuit board obtained from the circuit board laminate of FIGS. 5 and 6;
FIG. 8 is a cross-sectional view schematically showing a power module according to an embodiment;
FIG. 9 is an SEM photograph of a comparative inorganic filler manufactured by simple mixing, showing a state in which child particles (BN) do not adhere to mother particles (Al₂O₃) ;
FIG. 10A is a graph showing a size distribution of unsintered core-shell particles;
FIG. 10B is a graph showing a size distribution of unsintered core-shell particles after ultrasonic irradiation; and
FIG. 10C is a graph showing a size distribution of thermally conductive composite particles according to an embodiment after ultrasonic irradiation.

### DETAILED DESCRIPTION

Hereinafter, the present embodiment will be described.

### <Thermally Conductive Composite Particle>

A thermally conductive composite particle according to the present embodiment is a sintered body that includes a core portion including an inorganic particle, and a shell portion covering the core portion, in which the shell portion includes at least a nitride particle. Here, the nitride particle is preferably an inorganic compound having high thermal conductivity usable as an inorganic filler. With high thermal conductivity, even an inorganic compound having anisotropic thermal conductivity is used suitably as the nitride particle according to the present embodiment. Details will be described later.

The thermally conductive composite particle according to the present embodiment is a sintered body in which the inorganic particle and the nitride particle are combined. When the shell portion contains an atom derived from a sintering aid, the atom derived from the sintering aid is combined with the inorganic particle and/or the nitride particle. Such combination can be confirmed through, for example, X-ray diffraction (XRD) analysis, SEM observation, or particle size distribution.

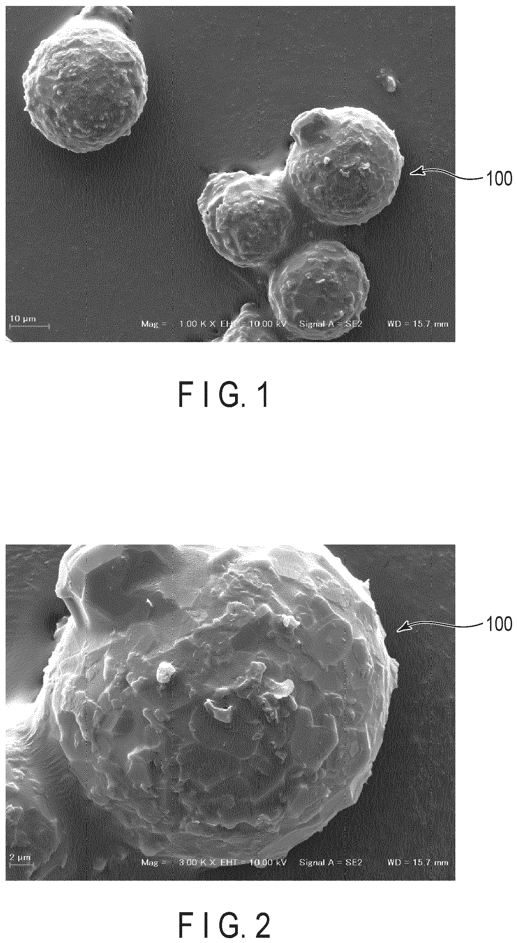

FIG. 1 shows an SEM photograph of a thermally conductive composite particle 100 according to the present embodiment, and FIG. 2 shows an enlarged view of that SEM photograph. It can be seen that the thermally conductive composite particle 100 shown in FIGS. 1 and 2 has an uneven surface, but a rounded shape as a whole.

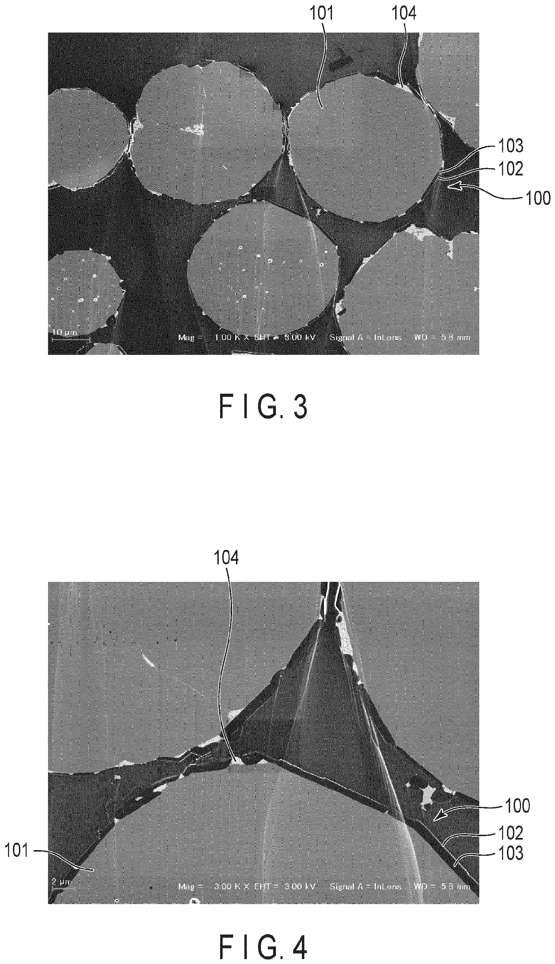

FIG. 3 shows an SEM photograph of a cross section of the thermally conductive composite particle 100, and FIG. 4 shows an enlarged view of that SEM photograph. The thermally conductive composite particle 100 shown in FIGS. 3 and 4 includes a core portion 101 composed of an inorganic particle, and a shell portion 102 covering the core portion. The shell portion 102 includes a nitride particle (boron nitride) 103 and an atom 104 derived from a sintering aid.

The cross-section photographs of FIGS. 3 and 4 show that in the thermally conductive composite particle 100 as a sintered body, the inorganic particle, the nitride particle, and the atom derived from the sintering aid are combined.

That is, a core-shell particle before sintering formed by mechanochemical treatment has a structure in which a periphery of an inorganic particle as a mother particle is covered with an aggregate of child particles, such as a nitride particle and a sintering aid which is added as necessary, and there is therefore a gap between the mother particle and the child particles. On the other hand, the cross-section photographs of FIGS. 3 and 4 show that the child particle of the nitride particle grows through sintering to form a plate-like (planar) nitride particle (boron nitride) 103, and the core portion (inorganic particle) 101 forms a plane along a shape of the plate-like (planar) nitride particle (boron nitride) 103, whereby the gap between the mother particle and the child particles in the core-shell particle before sintering disappears. Therefore, it is observed as a whole that the layered shell portion 102 containing the nitride particle (boron nitride) 103 and the atom 104 derived from the sintering aid grows on the surface of the core portion (inorganic particle) 101 to cover the core portion without gaps, and has a rounded shape as a whole. From them, it can be seen that the inorganic particle, the nitride particle, and the atom derived from the sintering aid are combined.

As described above, in the thermally conductive particle according to the present embodiment, the nitride particle and the atom derived from the sintering aid, which is used as necessary, are present in the form of covering the inorganic particle, and are strongly bonded to the inorganic particle by combination through sintering, having a rounded shape as a whole. Therefore, even if the nitride particle is a compound having high thermal conductivity but anisotropy, it functions as a highly thermally conductive inorganic filler having low anisotropy in the composite particle according to the present embodiment. In addition, the structure in which the core portion 101 (inorganic particle) is covered with the shell portion 102 on the layer including the nitride particle (boron nitride) 103 through sintering, without the formation of a gap, provides advantageous effects such as the securing of a thermal conduction path in the shell, and reduction of the likelihood of the shell portion peeling off.

In the present embodiment, the thickness of the layered shell portion covering the core portion is not particularly limited. Since the shell portion is a highly thermal-conductive portion, the lower limit of the thickness of the shell portion can be set as appropriate according to a desired thermal conductivity. The upper limit of the thickness of the shell portion may be a limit at which the shell portion can be produced by mechanochemical treatment described later. The shell portion does not need to cover the entire surface of the core portion, part of which may be left uncovered.

As described above, the shell portion 102 shown in FIGS. 3 and 4 includes the atom 104 derived from the sintering aid as an optional component in addition to the nitride particle (boron nitride) 103, and the atom 104 derived from the sintering aid is unevenly distributed on the surface of the core portion 101. The sintering aid has the effects of further enhancing the adhesion between the core portion and the shell portion by sintering and promoting the crystal growth of the shell portion, and is a compound suitably used in manufacturing of the thermally conductive composite particle according to the present embodiment. However, when the atom derived from the sintering aid is present in the shell portion of the thermally conductive composite particle after sintering, the thermal conductivity of the shell portion may be reduced. On the other hand, when the atom derived from the sintering aid is unevenly distributed on the surface of the core portion, a reduction in the thermal conductivity of the shell portion can be suppressed, which is preferable. In addition, the fact that the atom derived from the sintering aid is unevenly distributed on the surface of the core portion constituting the thermally conductive composite particle suggests that in the manufacturing process of the thermally conductive composite particle, the sintering aid first reacted with the surface of the core portion and this portion became a reaction field and a starting point of sintering. Therefore, the fact that the atom derived from the sintering aid is unevenly distributed on the surface of the core portion teaches that the sintering aid more effectively contributed to the improvement of the adhesion between the core portion and the shell portion and to the promotion of the crystal growth of the shell portion.

### <Method of Manufacturing Thermally Conductive Composite Particle>

A method of manufacturing a thermally conductive composite particle according to the present embodiment can be roughly divided into: a step including mechanochemical treatment for forming a core-shell particle including a core portion composed of an inorganic particle and a shell portion containing a nitride particle (provided that the inorganic particle and the nitride particle are not combined, hereinafter sometimes referred to as "unsintered core-shell particle"); and a step of forming a composite particle by sintering the core-shell particle (hereinafter sometimes referred to as "core-shell composite particle" with respect to the "unsintered core-shell particle"). More specifically, the method includes the following three steps, i.e., a simple mixing step of raw materials, a mechanochemical treatment step, and a sintering step. Note that the simple mixing step of raw materials is optional, and the raw material including the inorganic particle and the nitride particle may be subjected to the mechanochemical treatment without passing through the simple mixing step.

### - Simple mixing step of raw materials

This is a step of mixing raw materials, specifically, mixing inorganic particles as mother particles and nitride particles as child particles (and optional components as necessary such as a sintering aid described later). Here, mixing indicates simple mixing and can be performed by, for example, putting the raw materials into a container and stirring them.

### - Mechanochemical treatment step

The mixture obtained by the simple mixing step is subjected to mechanochemical treatment for applying a high-shear mechanical impact to thereby obtain core-shell particles in which peripheries of inorganic particles as mother particles are covered with child particles. Note that as described above, the mother particles and the child particles are not combined in the core-shell particles obtained by the mechanochemical treatment.

The mechanochemical treatment can be performed by publicly-known means using a mechanochemical apparatus. For example, it is preferable to perform treatment so as not to exceed each of the device maximum outputs of 9000 rpm, 750 W, and 3.7 A.

### - Sintering step

The core-shell particles obtained by the mechanochemical treatment are sintered, thereby obtaining composite particles (core-shell composite particles) having a core-shell structure in which mother particles and child particles are combined. The conditions for sintering are not particularly limited, and the sintering can be performed, for example, in an N₂ atmosphere at atmospheric pressures. The sintering temperature may be, for example, in the range of 1400 to 1800°C, but preferably set as appropriate according to the materials of inorganic particles, the presence or absence of the sintering aid, and the like.

If simple mixing of mother particles and child particles is only performed without mechanochemical treatment (for example, refer to Patent Literature 2, paragraph 0012), the mother particles and the child particles are rarely combined, and even if combination occurs, problems such as the aggregates of the child particles remaining or the child particles unevenly adhering to the mother particles occur, and it is therefore difficult to obtain core-shell particles.

In addition, if a mixture obtained by simple mixing is dispersed without sintering in a resin serving as a matrix (for example, refer to Patent Literature 2, Example 1 (paragraphs 0110 to 0114)), the mother particles and the child particles are separated and dispersed in the resin, and thus a desired high thermal conductivity cannot be obtained. Regarding this problem, reference can be made to Comparative Example 2 described later.

Even if a binder resin as a binder is used in the shell portion to obtain core-shell particles, when the core-shell particles are used as an inorganic filler only through drying without sintering (for example, refer to Patent Literature 1, paragraph 0043), the child particles and the mother particles are merely in contact with each other or attached to each other via the binder resin, and it is therefore difficult to obtain a desired thermal conductivity due to the presence of the grain boundaries or binder resin. Furthermore, the core-shell particles after drying contain the binder resin, the solvent of the binder resin, and the like remaining as impurities, which easily inhibit formation of thermal path. In addition, the smaller the size of the child particles, the more easily the child particles are aggregated to the mother particle, but the larger the filler, the better the thermal conductivity. Therefore, it is difficult to achieve both the aggregation property and the thermal conductivity at a high level.

### (Mother particle and Child particle)

In the core-shell particle, the mother particle serving as the core portion is an inorganic particle. The child particle contained in the shell portion is a nitride particle and an optional component such as a sintering aid used as necessary.

### - Inorganic particle (Mother particle)

The mother particle serving as the core portion is an inorganic particle. The inorganic particle may be an inorganic compound that can be used as a thermally conductive inorganic filler. Specific examples of the inorganic particle include aluminum oxide (Al₂O₃), magnesium oxide (MgO), aluminum nitride (AlN), and silicon oxide (SiO₂), and in one embodiment, aluminum oxide or magnesium oxide is preferable.

The shape of the inorganic particle is not particularly limited. The shape is preferably close to a spherical shape from the viewpoint of forming the core portion of the composite particle and the fillability into an insulating resin material.

The particle size of the inorganic particle as the mother particle is, in one embodiment, preferably 10 to 80 µm, more preferably 20 to 60 µm. Here, the particle size of the inorganic particle as the mother particle (for example, well-dispersible particle having a particle size of several dozen µm) is a particle size measured by the laser diffraction/scattering particle size distribution measuring apparatus (particle size distribution) La-960 HORIBA.

### - Nitride particle (Child particle)

As described above, the nitride particle contained in the shell portion is preferably an inorganic compound having high thermal conductivity that can be used as an inorganic filler. When the thermal conductivity is high, even an inorganic compound having anisotropy in thermal conductivity can be suitably used as the nitride particle according to the present embodiment. Specific examples of the nitride particle include boron nitride, silicon nitride, and aluminum oxide (Al₂O₃), and in one embodiment, boron nitride (BN) or silicon nitride (Si₃N₄) is preferable.

In the present embodiment, boron nitride used as the nitride particle is preferably low-crystalline boron nitride containing a large amount of B₂O₃ or oxygen as an impurity from the viewpoint of sinterability. In one embodiment, boron nitride used as the nitride particle is preferably boron nitride having a B₂O₃ content rate of 1% by mass or more or an oxygen content rate of 1% by mass or more as an impurity concentration, more preferably boron nitride having a B₂O₃ content rate of 5% by mass or more or an oxygen content rate of 5% by mass or more.

### - Sintering aid (Child particle)

In production of the thermally conductive composite particle according to the present embodiment, it is preferable to use a sintering aid. As described above, the sintering aid produces effects of further enhancing the adhesion between the core portion and the shell portion by sintering and promoting the crystal growth of the shell portion.

Specific examples of the sinter aid include Y₂O₃, CeO₂, La₂O₃, Yb₂O₃, TiO₂, ZrO₂, Fe₂O₃, MoO, MgO, Al₂O₃, CaO, B₄C, and B (metals), and one or two or more kinds of them can be used. In one embodiment, Y₂O₃ is preferable as a sintering aid. When a sintering aid is used, it is contained in the shell of the core-shell particle formed by mechanochemical treatment. The sintering aid reacts by sintering, and is mainly contained, as an atom derived from the sintering aid, in the shell portion of the thermally conductive composite particle according to the present embodiment. For example, when Y₂O₃ is used as the sintering aid, it is contained, as yttrium (Y), in the shell portion of the thermally conductive composite particle. As described above, when the atom derived from the sintering aid is contained in the shell portion of the core-shell composite particle, part of the atoms is unevenly distributed on the surface of the inorganic particle serving as the core portion.

The particle size of the child particles such as the nitride particle and the sintering aid is not particularly limited, and may be appropriately set according to the particle size of the mother particles constituting the core portion. In one embodiment, the upper limit of the particle size of the child particles can be set in a range of 100 to 800 nm.

When the sintering aid is used in the present embodiment, it is used preferably in a range of 1 to 50% by volume, more preferably in a range of 3 to 30% by volume, still more preferably in a range of 3 to 20% by volume, and even more preferably in a range of 5 to 10% by volume, with respect to the nitride particles as the raw material (child particle), from the viewpoint of thermal conductivity.

Further, the compounding ratio of the child particles to all raw material particles composed of the mother particles and the child particles is preferably as follows.

That is, if the sintering aid is not used, the ratio of the volume of the nitride particles to the total volume of the inorganic particles as the mother particles and the nitride particles as the child particles is preferably 5 to 35% by volume, more preferably 5 to 25% by volume or less.

On the other hand, if the sintering aid is used, the ratio of the total volume of the nitride particles and the sintering aid to the total volume of the inorganic particles as the mother particles, the nitride particles and the sintering aid as the child particles is preferably 20 to 60% by volume, more preferably 30 to 50% by volume.

### <Insulating Resin Composition>

The insulating resin composition according to the present embodiment contains a resin as a matrix, and the above-described thermally conductive composite particles.

The resin as the matrix is preferably a thermosetting resin, specific examples of which include an epoxy resin, a cyanate resin, a polyimide resin, a benzoxazine resin, an unsaturated polyester resin, a phenol resin, a melamine resin, a silicone resin, a bismaleimide resin, and an acrylic resin. Among them, one kind may be used alone, or two or more kinds may be used in combination. A resin other than the thermosetting resin may be further contained.

The ratio of the thermally conductive composite particles contained in the insulating resin composition according to the present embodiment is preferably 10 to 90% by volume, more preferably 50 to 80% by volume, based on the total volume of resin components.

The insulating resin composition according to the present embodiment may further contain a solvent or various additives such as a curing agent and a curing catalyst in addition to the above-described resin and thermally conductive composite particles. Furthermore, an inorganic filler other than the above-described thermally conductive composite particles may be further contained as long as the effects of the present invention are not diminished.

The method of manufacturing the insulating resin composition according to the present embodiment is not particularly limited, and publicly-known and commonly-used methods may be used. For example, it is prepared by mixing the thermally conductive composite particles and the thermosetting resin, and as necessary, a curing agent and other components, by a publicly-known and commonly-used method.

### <Insulating Resin Molded Article>

The insulating resin molded article according to the present embodiment is a molded article obtained by molding the above-described insulating resin composition by various molding methods. As a molding method, a publicly-known and commonly-used method of molding a thermosetting resin can be used, specific examples of which include a press molding method, a thermoforming method, and a lamination method. The shape, dimension, etc. of the insulating resin molded article can be appropriately set in accordance with its application.

### <Circuit Board Laminate>

The circuit board laminate according to the present embodiment includes a metal substrate, an insulating layer provided on at least one surface of the metal substrate, and a metal foil provided on the insulating layer, and the feature is that the insulating layer contains the above-described thermally conductive composite particles.

Hereinafter, the circuit board laminate according to the present embodiment will be described in detail with reference to the drawings.

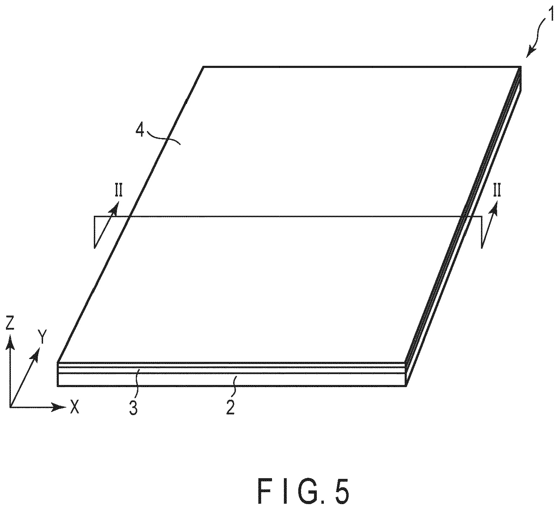

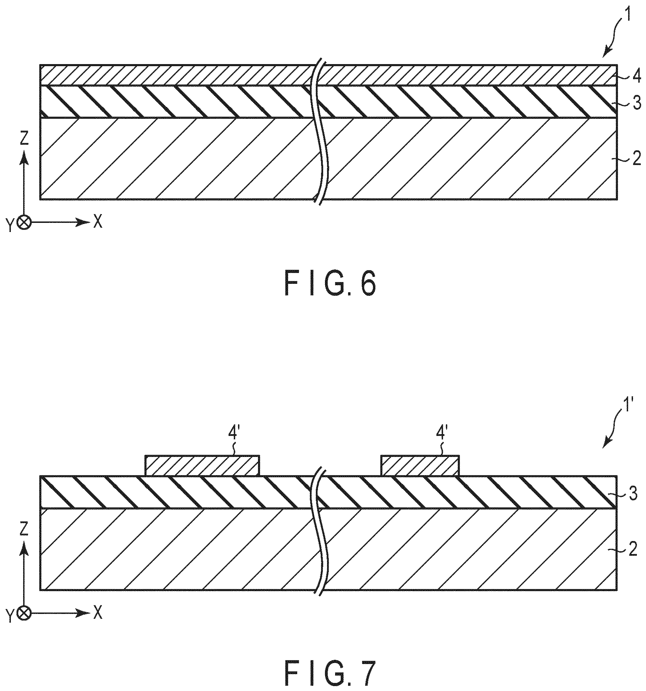

A circuit board laminate 1 shown in FIGS. 5 and 6 has a three-layer structure in which an insulating layer 3 is formed on one surface of a metal substrate 2, and a metal foil 4 is formed on the insulating layer 3. In another embodiment of the present invention, a five-layer structure may be employed in which insulating layers 3 are formed on both surfaces of a metal plate 2, and metal foils 4 are formed on the respective insulating layers 3. In FIGS. 5 and 6, X and Y directions are parallel to the main surface of the metal substrate 2 and orthogonal to each other, and Z direction is a thickness direction perpendicular to the X and Y directions. Although FIG. 5 shows a rectangular circuit board laminate 1 as an example, the circuit board laminate 1 may have other shapes.

The insulating layer 3 includes the above-described thermally conductive composite particles, and the thermally conductive composite particles are dispersed as an inorganic filler in a resin. In one embodiment, the insulating layer 3 is formed using the above-described insulating resin composition. Therefore, the above description of the insulating resin composition can be applied to components other than the thermally conductive composite particles contained in the insulating layer 3 as well as the compounding ratio of the thermally conductive composite particles and the resin.

The metal substrate 2 is made of, for example, a single metal or an alloy. As a material of the metal substrate 2, for example, aluminum, iron, copper, an aluminum alloy, or stainless steel can be used. The metal substrate 2 may further include a non-metal such as carbon. For example, the metal substrate 2 may include aluminum combined with carbon. The metal substrate 2 may have a single-layer or multi-layer structure.

The metal substrate 2 has a high thermal conductivity. Typically, the metal substrate 2 has a thermal conductivity of 60 W·m⁻¹·K⁻¹ or more.

The metal substrate 2 may or may not have flexibility. The metal substrate 2 has a thickness in a range of, for example, 0.2 to 5 mm.

The metal foil 4 is provided on the insulating layer 3. The metal foil 4 faces the metal substrate 2 with the insulating layer 3 interposed therebetween.

The metal foil 4 is made of, for example, a single metal or an alloy. As a material of the metal foil 4, for example, copper or aluminum can be used. The metal foil 4 has a thickness in a range of, for example, 10 to 500 µm.

Since the insulating layer 3 contains the above-described thermally conductive composite particles, the circuit board laminate 1 has excellent thermal conductivity.

The circuit board laminate 1 is manufactured by, for example, the following method.

First, the above-described insulating resin composition is applied to at least one of the metal substrate 2 or the metal foil 4. For application of the insulating resin composition, for example, a roll coating method, a bar coating method, or a screen printing method can be used. The application method may be a continuous method or a single plate method.

After the coating film is dried as necessary, the metal substrate 2 and the metal foil 4 are superposed so as to face each other with the coating film interposed therebetween. Further, they are heat-pressed. In this manner, the circuit board laminate 1 is obtained.

In this method, the coating film is formed by applying the insulating resin composition to at least one of the metal plate 2 or the metal foil 4; however, in another embodiment, the coating film may be formed in advance by applying the insulating resin composition to a base material such as a PET film and drying, and thermally transferring this to one of the metal substrate 2 or the metal foil 4.

### <Metal Base Circuit Board>

The metal base circuit board according to the present embodiment includes a metal substrate, an insulating layer provided on at least one surface of the metal substrate, and a metal pattern provided on the insulating layer, and the feature is that the insulating layer contains the above-described thermally conductive composite particles.

Hereinafter, the metal base circuit board according to the present embodiment will be described in detail with reference to the drawings.

A metal base circuit board 1' shown in FIG. 7 is obtainable from the circuit board laminate shown in FIGS. 5 and 6, and includes the metal substrate 2, the insulating layer 3, and a circuit pattern 4'. The circuit pattern 4' is obtainable by patterning the metal foil 4 of the circuit board laminate described with reference to FIGS. 5 and 6. This patterning is obtainable by, for example, forming a mask pattern on the metal foil 4, and removing an exposed portion of the metal foil 4 by etching. The metal base circuit board 1' is obtainable by, for example, performing the above-described patterning on the metal foil 4 of the circuit board laminate 1 described earlier, and, as necessary, performing processing such as cutting and drilling processing.

The metal base circuit board 1' includes the above-described thermally conductive composite particles in the insulating layer 3, and therefore has excellent thermal conductivity.

The power module according to the present embodiment includes the above-described metal base circuit board.

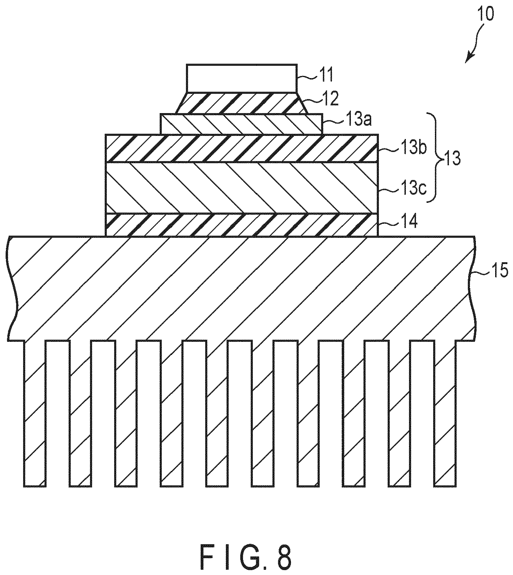

FIG. 8 shows an example of the power module according to the present embodiment. The power module 10 shown in FIG. 8 includes a heat sink 15, a heat dissipation sheet 14, a metal base circuit board 13, a solder layer 12, and a power device 11, laminated in this order. The metal base circuit board 13 included in the power module 10 is formed by laminating a metal substrate 13c, an insulating layer 13b, and a circuit pattern 13a in this order. Since the insulating layer 13b includes the above-described thermally conductive composite particles, the power module 10 has excellent thermal conductivity.

### Examples

Hereinafter, the present embodiment will be described in a concrete manner with examples.

### <Example 1>

### [Manufacturing of Thermally Conductive Composite Particle 1]

Mother particles X: Al₂O₃ (Denka spherical alumina DAW-45, manufactured by Denka Company Limited, D₅₀ = 45 µm); and
Child particles a: BN (AP-170S, manufactured by Maruka Corporation, particle size of 20 nm, O₂ content rate of 7.2% by mass).

The mother particles X (Al₂O₃) and the child particles a (BN) were put into Nobilta Mini (manufactured by HOSOKAWA MICRON CORPORATION) at a volumetric ratio of child particles a / total particles (child particles a + mother particles X) = 1/(1+9) = 0.10, and mechanochemical treatment was performed at a rotation speed of 6000 to 8000 rpm for 3 minutes, thereby obtaining unsintered core-shell particles 1a. The unsintered core-shell particles 1a were sintered at 1800°C for 3 hours in an N₂ atmosphere at atmospheric pressures, thereby obtaining thermally conductive composite particles 1.

### [Manufacturing of Insulating Resin Molded Article 1]

The thermally conductive composite particles 1 were mixed with the resin composition of the bisphenol A (EPICLON EXA-850CRP, manufactured by DIC Corporation) and the amine-based curing agent (jER CURE W, manufactured by Mitsubishi Chemical Corporation) at a bisphenol A : amine-based curing agent ratio of 4 : 1 (mass ratio) so that the content rate was 70% by volume. The mixture was defoamed and stirred, then dried at 90°C for 2 hours. Next, heating was performed at 100°C for 2 hours while pressure was applied at 12 MPa in vacuum, and heating was further performed at 175°C for 5 hours, thereby obtaining an insulating resin molded article 1.

### <Example 2>

### [Manufacturing of Thermally Conductive Composite Particle 2]

Mother particles X: Al₂O₃ (Denka spherical alumina DAW-45, manufactured by Denka Company Limited, D₅₀ = 45 µm);
Child particles a: BN (AP-170S, manufactured by Maruka Corporation, particle size of 20 nm, O₂ content rate of 7.2% by mass); and
Child particles b: Y₂O₃ (fine particle product (high BET), manufactured by Nippon Yttrium Co., Ltd.).

Unsintered core-shell particles 2a were obtained under the same conditions as those for the unsintered core-shell particles 1a of Example 1, except for the use of the child particles obtained by adding 5% by volume of the child particles b to the child particles a (100% by volume) and adjusting the volume of the mother particles X so that the child particle ratio was 0.1. Next, the unsintered core-shell particles 2a were sintered under the same sintering conditions as in Example 1, thereby obtaining thermally conductive composite particles 2.

### [Manufacturing of Insulating Resin Molded Article 2]

An insulating resin molded article 2 was obtained under the same manufacturing conditions as those for the insulating resin molded article 1 in Example 1, except for the use of the thermally conductive composite particles 2 instead of the thermally conductive composite particles 1.

### <Example 3>

### [Manufacturing of Thermally Conductive Composite Particle 3]

Thermally conductive composite particles 3 were obtained under the same manufacturing conditions as those of the thermally conductive composite particles 2 in Example 2, except for the use of the child particles obtained by adding 10% by volume of the child particles b to the child particles a (100% by volume) and adjusting the volume of the mother particles X so that the child particle ratio was 0.1.

### [Manufacturing of Insulating Resin Molded Article 3]

An insulating resin molded article 3 was obtained under the same manufacturing conditions as those for the insulating resin molded article 2 in Example 2, except for the use of the thermally conductive composite particles 3 instead of the thermally conductive composite particles 2.

### <Example 4>

### [Manufacturing of Thermally Conductive Composite Particle 4]

Thermally conductive composite particles 4 were obtained under the same manufacturing conditions as those of the thermally conductive composite particles 2 in Example 2, except for the use of the child particles obtained by adding 20% by volume of the child particles b to the child particles a (100% by volume) and adjusting the volume of the mother particles X so that the child particle ratio was 0.1.

### [Manufacturing of Insulating Resin Molded Article 4]

An insulating resin molded article 4 was obtained under the same manufacturing conditions as those for the insulating resin molded article 2 in Example 2, except for the use of the thermally conductive composite particles 4 instead of the thermally conductive composite particles 2.

### <Example 5>

### [Manufacturing of Thermally Conductive Composite Particle 5]

Unsintered core-shell particles 5a were obtained under the same conditions as those for the unsintered core-shell particles 1a in Example 1, except that in the manufacturing of the thermally conductive composite particles 1 in Example 1, the compounding ratio (volumetric ratio) of the mother particles (Al₂O₃) and the child particles (BN) was changed to a ratio of child particles/total particles (child particles + mother particles) = 2/(2+8) = 0.20. Next, the unsintered core-shell particles 5a were sintered under the same sintering conditions as in Example 1, thereby obtaining thermally conductive composite particles 5.

### [Manufacturing of Insulating Resin Molded Article 5]

An insulating resin molded article 5 was obtained under the same manufacturing conditions as those for the insulating resin molded article 1 in Example 1, except for the use of the thermally conductive composite particles 5 instead of the thermally conductive composite particles 1.

### <Example 6>

### [Manufacturing of Thermally Conductive Composite Particle 6]

Unsintered core-shell particles 6a were obtained under the same conditions as those for the unsintered core-shell particles 5a of Example 5, except for the use of the child particles obtained by adding 5% by volume of the child particles b to the child particles a (100% by volume) and adjusting the volume of the mother particles X so that the child particle ratio was 0.2. Next, the unsintered core-shell particles 6a were sintered under the same sintering conditions as in Example 5, thereby obtaining thermally conductive composite particles 6.

### [Manufacturing of Insulating Resin Molded Article 6]

An insulating resin molded article 6 was obtained under the same manufacturing conditions as those for the insulating resin molded article 5 in Example 5, except for the use of the thermally conductive composite particles 6 instead of the thermally conductive composite particles 5.

### <Example 7>

### [Manufacturing of Thermally Conductive Composite Particle 7]

Thermally conductive composite particles 7 were obtained under the same manufacturing conditions as those of the thermally conductive composite particles 6 in Example 6, except for the use of the child particles obtained by adding 10% by volume of the child particles b to the child particles a (100% by volume) and adjusting the volume of the mother particles X so that the child particle ratio was 0.2.

### [Manufacturing of Insulating Resin Molded Article 7]

An insulating resin molded article 7 was obtained under the same manufacturing conditions as those for the insulating resin molded article 6 in Example 6, except for the use of the thermally conductive composite particles 7 instead of the thermally conductive composite particles 6.

### <Example 8>

### [Manufacturing of Thermally Conductive Composite Particle 8]

Thermally conductive composite particles 8 were obtained under the same manufacturing conditions as those of the thermally conductive composite particles 6 in Example 6, except for the use of the child particles obtained by adding 20% by volume of the child particles b to the child particles a (100% by volume) and adjusting the volume of the mother particles X so that the child particle ratio was 0.2.

### [Manufacturing of Insulating Resin Molded Article 8]

An insulating resin molded article 8 was obtained under the same manufacturing conditions as those for the insulating resin molded article 6 in Example 6, except for the use of the thermally conductive composite particles 8 instead of the thermally conductive composite particles 6.

### <Example 9>

### [Manufacturing of Thermally Conductive Composite Particle 9]

Unsintered core-shell particles 9a were obtained under the same conditions as those for the unsintered core-shell particles 1a in Example 1, except that in the manufacturing of the thermally conductive composite particles 1 in Example 1, the compounding ratio (volumetric ratio) of the mother particles (Al₂O₃) and the child particles (BN) was changed to a ratio of child particles / total particles (child particles + mother particles) = 3/(3+7) = 0.30. Next, the unsintered core-shell particles 9a were sintered under the same sintering conditions as in Example 1, thereby obtaining thermally conductive composite particles 9.

### [Manufacturing of Insulating Resin Molded Article 9]

An insulating resin molded article 9 was obtained under the same manufacturing conditions as those for the insulating resin molded article 1 in Example 1, except for the use of the thermally conductive composite particles 9 instead of the thermally conductive composite particles 1.

### <Example 10>

### [Manufacturing of Thermally Conductive Composite Particle 10]

Unsintered core-shell particles 10a were obtained under the same conditions as those for the unsintered core-shell particles 9a of Example 9, except for the use of the child particles obtained by adding 5% by volume of the child particles b to the child particles a (100% by volume) and adjusting the volume of the mother particles X so that the child particle ratio was 0.3. Next, the unsintered core-shell particles 10a were sintered under the same sintering conditions as in Example 9, thereby obtaining thermally conductive composite particles 10.

### [Manufacturing of Insulating Resin Molded Article 10]

An insulating resin molded article 10 was obtained under the same manufacturing conditions as those for the insulating resin molded article 9 in Example 9, except for the use of the thermally conductive composite particles 10 instead of the thermally conductive composite particles 9.

### <Example 11>

### [Manufacturing of Thermally Conductive Composite Particle 11]

Thermally conductive composite particles 11 were obtained under the same manufacturing conditions as those of the thermally conductive composite particles 10 in Example 10, except for the use of the child particles obtained by adding 10% by volume of the child particles b to the child particles a (100% by volume) and adjusting the volume of the mother particles X so that the child particle ratio was 0.3.

### [Manufacturing of Insulating Resin Molded Article 11]

An insulating resin molded article 11 was obtained under the same manufacturing conditions as those for the insulating resin molded article 10 in Example 10, except for the use of the thermally conductive composite particles 11 instead of the thermally conductive composite particles 10.

### <Example 12>

### [Manufacturing of Thermally Conductive Composite Particle 12]

Thermally conductive composite particles 12 were obtained under the same manufacturing conditions as those for the thermally conductive composite particles 1 in Example 1, except that in the manufacturing of the thermally conductive composite particles 1 in Example 1, the compounding ratio (volumetric ratio) of the mother particles (Al₂O₃) and the child particles a (BN) was set to child particles a / total particles (child particles a + mother particles X) = 5/(5+5) = 0.5, 5% by volume of the child particles b (Y₂O₃) was further added to the child particles a (100% by volume), and the volume of the mother particles X was adjusted so that the child particle ratio was 0.5.

### [Manufacturing of Insulating Resin Molded Article 12]

An insulating resin molded article 12 was obtained under the same manufacturing conditions as those for the insulating resin molded article 1 in Example 1, except for the use of the thermally conductive composite particles 12 instead of the thermally conductive composite particles 1.

### <Example 13>

### [Manufacturing of Thermally Conductive Composite Particle 13]

Thermally conductive composite particles 13 were obtained under the same manufacturing conditions as those of the thermally conductive composite particles 12 in Example 12, except for the use of the child particles obtained by adding 10% by volume of the child particles b to the child particles a (100% by volume) and adjusting the volume of the mother particles X so that the child particle ratio was 0.5.

### [Manufacturing of Insulating Resin Molded Article 13]

An insulating resin molded article 13 was obtained under the same manufacturing conditions as those for the insulating resin molded article 12 in Example 12, except for the use of the thermally conductive composite particles 13 instead of the thermally conductive composite particles 12.

### <Comparative Example 1>

### [Thermally Conductive Filler 1R]

As a thermally conductive filler, a thermally conductive filler 1R made of Al₂O₃ (Denka spherical alumina DAW-45, manufactured by Denka Company Limited, D₅₀ = 45 µm) was used.

### [Manufacturing of Insulating Resin Molded Article 1R]

An insulating resin molded article 1R was obtained under the same manufacturing conditions as those for the insulating resin molded article 1 in Example 1, except for the use of the above-described thermally conductive filler 1R made of Al₂O₃ instead of the thermally conductive composite particles 1.

### <Comparative Example 2>

### [Thermally Conductive Filler 2R]

Mother particles X: Al₂O₃ (Denka spherical alumina DAW-45, manufactured by Denka Company Limited, D₅₀ = 45 µm) ; and
Child particles a: BN (PT-120, manufactured by Momentive Performance Materials Inc., D₅₀ = 12 µm).

The mother particles X (Al₂O₃) and the child particles a (BN) were put into a container at a volumetric ratio of child particles a / total particles (child particles a + mother particles X) = 1/(1+9) = 0.10, and stirred (simply mixed), thereby obtaining a thermally conductive filler 2R.

### [Manufacturing of Insulating Resin Molded Article 2R]

An insulating resin molded article 2R was obtained under the same manufacturing conditions as those for the insulating resin mold article 1 in Example 1, except for using the thermally conductive filler 2R instead of the thermally conductive composite particles 1.

### <Comparative Example 3>

### [Thermally Conductive Filler 3R]

Mother particles X: Al₂O₃ (Denka spherical alumina DAW-45, manufactured by Denka Company Limited, D₅₀ = 45 µm) ; and
Child particles a: BN (AP-170S, manufactured by Maruka Corporation, particle size of 20 nm, O₂ content rate of 7.2% by mass).

The mother particles X (Al₂O₃) and the child particles a (BN) were put into a container at a volumetric ratio of child particles a / total particles (child particles a + mother particles X) = 1/(1+9) = 0.10, and stirred (simply mixed), thereby obtaining a thermally conductive filler 3R.

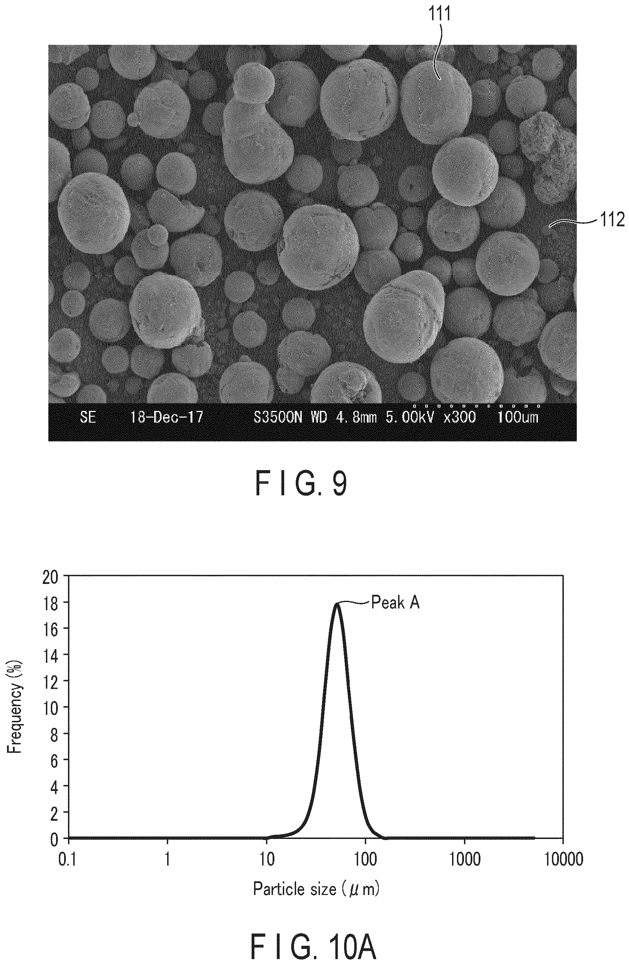

FIG. 9 shows an SEM photograph of the thermally conductive filler 3R. It can be seen that the BN particles 112 of the child particles do not adhere to the Al₂O₃ particles 111 of the mother particles, and the Al₂O₃ particles 111 and the BN particles 112 are separated from each other.

### <Verification of Combination in Thermally Conductive Composite Particle>

Using the unsintered core-shell particles 2a obtained in Example 2 and the thermally conductive composite particles 2 as sintered bodies thereof, it was verified, through ultrasonic irradiation and particle size distribution measurement, that the thermally conductive composite particles as sintered bodies were combined. For the ultrasonic irradiation and particle size distribution measurement, the "laser diffraction/scattering particle size distribution measuring apparatus (particle size distribution) La-960 HORIBA" was used.

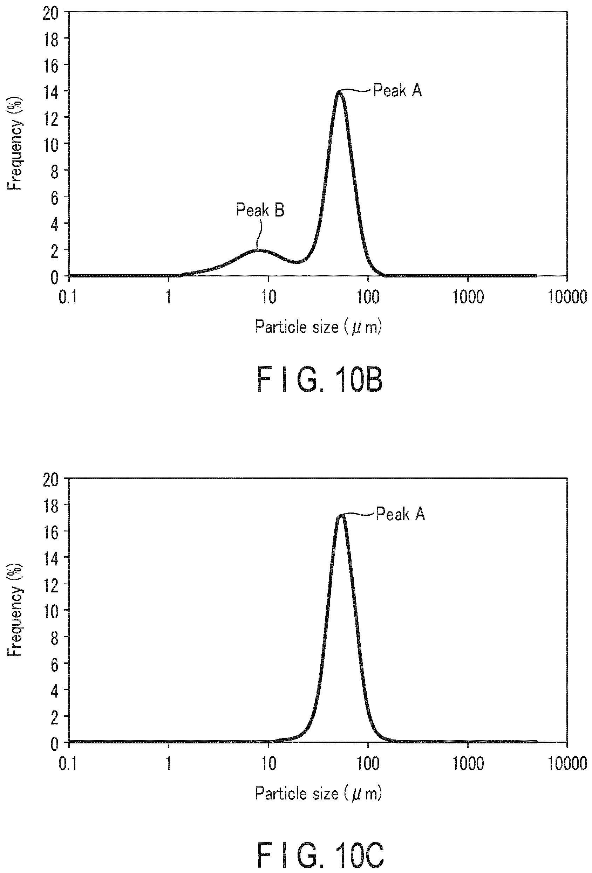

FIG. 10A is a graph showing the size distribution of the unsintered core-shell particles 2a obtained by mechanochemical treatment in Example 2. In the graph, the unsintered core-shell particles 2a have a peak A in the vicinity of a particle size of 80 µm. FIG. 10B is a graph showing the size distribution of the unsintered core-shell particles 2a after ultrasonic irradiation for 60 seconds. In the graph, the unsintered core-shell particles 2a after the ultrasonic irradiation have a peak A in the vicinity of a particle size of 80 µm, and a peak B in the vicinity of a particle size of 10 µm.

FIG. 10C is a graph showing the size distribution of the thermally conductive composite particles 2 after they were irradiated with ultrasonic waves for 60 seconds, and the thermally conductive composite particles 2 are sintered bodies of the unsintered core-shell particles 2a. In the graph, the thermally conductive composite particles 2 after ultrasonic irradiation have a peak A in the vicinity of a particle size of 80 µm.

The comparison between FIG. 10A and FIG. 10B indicates that in the particle size distribution shown in FIG. 10B after ultrasonic irradiation for 60 seconds, the peak A decreases while the peak B increases with respect to the particle size distribution before ultrasonic irradiation shown in FIG. 10A. Accordingly, it was confirmed that the core-shell structures were partially broken as a result of irradiating the unsintered core-shell particles 2a with ultrasonic waves for 60 seconds.

On the other hand, the comparison between FIG. 10A and FIG. 10C indicates that the particle size distributions of both of them have the same peak A. Accordingly, it was confirmed that the core-shell structures of the thermally conductive composite particles 2 were not broken even after irradiation of the ultrasonic wave for 60 seconds and the particles were combined.

### <Evaluation Method of Thermal Conductivity>

The thermal conductivity was evaluated according to the following procedure.

Each of the obtained insulating resin molded articles was processed into a size of 10 mm × 10 mm to be used as a sample. The thermal conductivity was calculated by multiplying all of thermal diffusivity, specific gravity, and specific heat of the sample.

A xenon-flash analyzer (LFA467 HyperFlash (registered trademark) manufactured by NETZSCH) was used as a measuring apparatus. The thermal diffusivity was obtained by a laser flash method. The specific gravity was obtained using the Archimedes method. The specific heat was obtained by raising the temperature from room temperature to 700°C at a temperature rising rate of 10°C/min in a nitrogen atmosphere, using a differential scanning calorimeter ("Q2000", manufactured by TA Instruments).

The results are shown in Table 1.

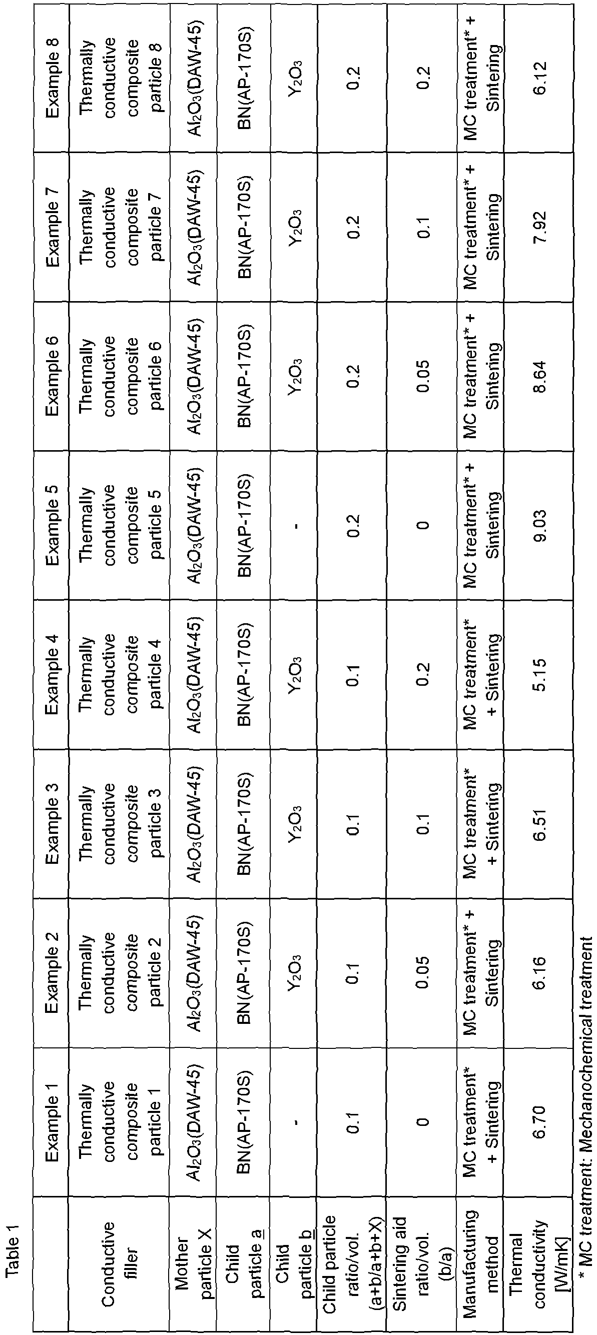

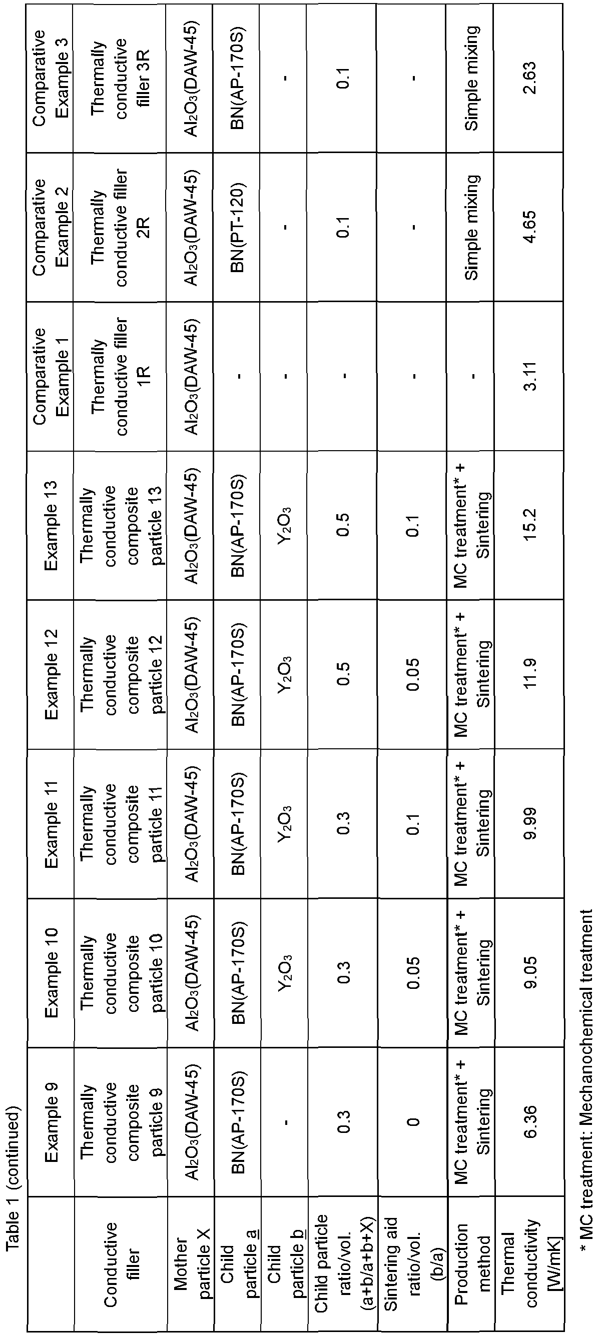

The present invention is not limited to the above-described embodiments, and various modifications can be made without departing from the scope of the present invention. In addition, the embodiments may be appropriately combined and implemented, and in this case, combined effects are obtained. Furthermore, various inventions are included in the above-described embodiments, and various inventions can be extracted by a combination selected from a plurality of disclosed constituent elements. For example, even if some constituent elements are deleted from all the constituent elements in the embodiments, when the problem can be solved and the effect can be obtained, the configuration from which the constituent elements are deleted can be extracted as the invention.

### REFERENCE SIGNS LIST

- 1: circuit board laminate
- 1': metal base circuit board
- 2: metal substrate
- 3: insulating layer
- 4: metal foil
- 4': circuit pattern
- 10: power module
- 11: power device
- 12: solder layer
- 13: metal base circuit board
- 13a: circuit pattern
- 13b: insulating layer
- 13c: metal substrate
- 14: heat dissipation sheet
- 15: heat sink
- 100: thermally conductive composite particle
- 101: core portion (inorganic particle)
- 102: shell portion
- 103: nitride particle (boron nitride)
- 104: atom derived from sintering aid
- 111: Al₂O₃ particle
- 112: BN particle

## Claims

1. A thermally conductive composite particle as a sintered body, comprising:
a core portion including an inorganic particle; and
a shell portion including a nitride particle and covering the core portion.

2. The thermally conductive composite particle according to claim 1, including at least boron nitride or silicon nitride as the nitride particle.

3. The thermally conductive composite particle according to claim 1 or 2, wherein at least part of the shell portion is layered, and covers at least part of the core portion along a shape of the core portion.

4. The thermally conductive composite particle according to any one of claims 1 to 3, wherein the shell portion is a sintered member of a mixture including the nitride particle and a sintering aid, and the shell portion includes an atom derived from the sintering aid.

5. The thermally conductive composite particle according to claim 4, wherein the sintering aid is at least one selected from Y₂O₃, CeO₂, La₂O₃, Yb₂O₃, TiO₂, ZrO₂, Fe₂O₃, MoO, MgO, Al₂O₃, CaO, B₄C, or B.

6. The thermally conductive composite particle according to claim 4 or 5, wherein part of the atoms derived from the sintering aid is unevenly distributed on a surface of the core portion.

7. The thermally conductive composite particle according to any one of claims 4 to 6, wherein the shell portion includes at least yttrium as the atom derived from the sintering aid.

8. The thermally conductive composite particle according to any one of claims 4 to 7, wherein a total volume of the nitride particle and the sintering aid with respect to a total volume of the inorganic particle, the nitride particle, and the sintering aid is 30% by volume or more.

9. The thermally conductive composite particle according to any one of claims 4 to 8, wherein a compounding ratio of the sintering aid to the nitride particle is 5% by volume to 10% by volume.

10. The thermally conductive composite particle according to any one of claims 1 to 9, wherein the inorganic particle is aluminum oxide or magnesium oxide.

11. A method of manufacturing a thermally conductive composite particle as a sintered body, the particle comprising a core portion including an inorganic particle, and a shell portion including a nitride particle and covering the core portion, the method comprising:
forming a core-shell particle by subjecting a raw material including the inorganic particle and the nitride particle to mechanochemical treatment, the core-shell particle comprising a core portion including the inorganic particle, and a shell portion including the nitride particle and covering the core portion; and
sintering the core-shell particle.

12. The method according to claim 11, including at least boron nitride or silicon nitride as the nitride particle included in the shell portion of the thermally conductive composite particle.

13. The method according to claim 11 or 12, wherein boron nitride, having at least a B₂O₃ content rate of 1% by mass or more or an oxygen content rate of 1% by mass or more as an impurity concentration, is used as the nitride particle of the raw material.

14. The method according to any one of claims 11 to 13, wherein the raw material further includes at least one sintering aid selected from Y₂O₃, CeO₂, La₂O₃, Yb₂O₃, TiO₂, ZrO₂, Fe₂O₃, MoO, MgO, Al₂O₃, CaO, B₄C, or B, and
the shell portion of the thermally conductive composite particle includes an atom derived from the sintering aid.

15. The method according to claim 14, wherein part of the atoms derived from the sintering aid is unevenly distributed on a surface of the core portion of the thermally conductive composite particle.

16. The method according to claim 14 or 15, wherein the raw material includes at least Y₂O₃ as the sintering aid, and the atom derived from the sintering aid is yttrium.

17. The method according to any one of claims 14 to 16, wherein a total volume of the nitride particle and the sintering aid with respect to a total volume of the inorganic particle, the nitride particle, and the sintering aid included in the raw material is 30% by volume or more.

18. The method according to any one of claims 14 to 17, wherein a ratio of the sintering aid to the nitride particle included in the raw material is 5 to 10% by volume.

19. The method according to any one of claims 11 to 18, wherein the inorganic particle is aluminum oxide or magnesium oxide.

20. An insulating resin composition, comprising the thermally conductive composite particle according to any one of claims 1 to 10.

21. An insulating resin molded article, obtainable by molding the insulating resin composition according to claim 20.

22. A circuit board laminate comprising:
a metal substrate;
an insulating layer provided on at least one surface of the metal substrate; and
a metal foil provided on the insulating layer,
the insulating layer comprising the thermally conductive composite particle according to any one of claims 1 to 10.

23. A metal base circuit board comprising:
a metal substrate;
an insulating layer provided on at least one surface of the metal substrate; and
a metal pattern provided on the insulating layer,
the insulating layer comprising the thermally conductive composite particle according to any one of claims 1 to 10.

24. A power module, comprising the metal base circuit board according to claim 23.
